(19) Europäisches Patentamt / European Patent Office / Office européen des brevets

(11) **EP 2 311 094 B1**

(12) **EUROPEAN PATENT SPECIFICATION**

(45) Date of publication and mention
of the grant of the patent:
**01.01.2014 Bulletin 2014/01**

(21) Application number: **08794914.5**

(22) Date of filing: **31.07.2008**

(51) Int Cl.:
*H01L 29/872* (2006.01)   *H01L 29/861* (2006.01)

(86) International application number:
**PCT/US2008/009246**

(87) International publication number:
**WO 2010/014064 (04.02.2010 Gazette 2010/05)**

(54) **MULTI-LAYER RECONFIGURABLE SWITCHES**

MEHRSCHICHTIGE UMKONFIGURIERBARE SCHALTER

COMMUTATEURS RECONFIGURABLES MULTICOUCHES

(84) Designated Contracting States:
**AT BE BG CH CY CZ DE DK EE ES FI FR GB GR HR HU IE IS IT LI LT LU LV MC MT NL NO PL PT RO SE SI SK TR**

(43) Date of publication of application:
**20.04.2011 Bulletin 2011/16**

(73) Proprietor: **Hewlett-Packard Development Company, L.P.
Houston, TX 77070 (US)**

(72) Inventors:
• **YANG, Jianhua**
 **Palo Alto**
 **California 94304 (US)**
• **BORGHETTI, Julien**
 **Palo Alto**
 **California 94304 (US)**
• **STEWART, Duncan**
 **Palo Alto**
 **California 94304 (US)**
• **WILLIAMS, R. Stanley**
 **Palo Alto**
 **California 94304 (US)**

(74) Representative: **Baldwin, Mark
Firebird IP
40 Bowling Green Lane
London EC1R 0NE (GB)**

(56) References cited:
 **EP-A2- 0 190 605      WO-A2-2006/044324
 JP-A- 2004 022 904     JP-A- 2007 184 382
 US-A1- 2006 141 713    US-A1- 2008 079 029
 US-B1- 6 727 525**

• **SHIN YONG ET AL: "(In,Sn)2O3â TiO2â Pt Schottky-type diode switch for the TiO2 resistive switching memory array", APPLIED PHYSICS LETTERS, AIP, AMERICAN INSTITUTE OF PHYSICS, MELVILLE, NY, US, vol. 921-5, no. 16, 25 April 2008 (2008-04-25), pages 162904-162904, XP012106615, ISSN: 0003-6951, DOI: 10.1063/1.2912531**
• **SCHIERBAUM K D ET AL: "Schottky-barrier and conductivity gas sensors based upon Pd/SnO2 and Pt/TiO2", SENSORS AND ACTUATORS B: CHEMICAL: INTERNATIONAL JOURNAL DEVOTED TO RESEARCH AND DEVELOPMENT OF PHYSICAL AND CHEMICAL TRANSDUCERS, ELSEVIER S.A, SWITZERLAND, vol. 4, no. 1-2, 1 May 1991 (1991-05-01), pages 87-94, XP026577088, ISSN: 0925-4005, DOI: 10.1016/0925-4005(91)80181-I [retrieved on 1991-05-01]**

## Description

TECHNICAL FIELD

Embodiments of the present invention are related to nanoscale electronic devices, and, in particular, to re-configurable diode switches that can be implemented in crossbar arrays.

BACKGROUND

Significant research and development efforts are currently directed towards designing and manufacturing nanoscale electronic devices, such as nanoscale memories. Nanoscale electronics promise a number of advantages over microscale, photolithography-based electronics, including significantly reduced features sizes and the potential for self-assembly and for other relatively inexpensive, non-photolithography-based fabrication methods. However, the design and manufacture of nanoscale electronic devices present many new problems need to be addressed before large-scale commercial production of nanoscale electronic devices and incorporation of nanoscale electronic devices into microscale and larger-scale systems, devices, and products.

Studies of switching in nanometer-scale crossed-wire devices have previously reported that these devices could be reversibly switched and had an "on-to-off" conductance ratio of $\sim 10^3$. These devices have been used to construct crossbar circuits and provide a promising route for the creation of ultra-high density nonvolatile memory. A series connection of cross-wire switches that can be used to fabricate a latch has also been demonstrated, such a latch is an important component for logic circuits and for communication between logic and memory. New logic families that can be constructed entirely from crossbar arrays of switches or as hybrid structures composed of switches and transistors have been described. These new logic families have the potential to dramatically increase the computing efficiency of CMOS circuits, thereby enabling performance improvements of orders of magnitude without having to shrink transistors, or to even replace CMOS for some applications if necessary. However, it is desired to improve the performance of the devices that are presently fabricated.

Patent application EP 0190605 (Max Planck Gesellschaft) discloses a semiconductor diode where ions move in the semiconductor body.

SUMMARY

Various embodiments of the present invention are direct to nanoscale, reconfigurable, two-terminal electronic switches. In one embodiment, an electronic switch includes a first electrode, a second electrode, and an active region disposed between the first electrode and the second electrode and including at least one dopant. The switch can be re-configured to operate as a forward rectifier, a reverse rectifier, a shunted rectifier, or a head-to-head rectifier by positioning the dopant within the active region in order to control the flow of charge carriers through the switch.

BRIED DESCRIPTION OF THE DRAWINGS

Figure 1A shows a two-terminal switch configured in accordance with embodiments of the present invention.

Figure 1B shows profiles of tunneling barriers associated with four rectifiers configured in accordance with embodiments of the present invention.

Figure 2 shows plots of current-versus-voltage curves associated with the four rectifiers shown in Figure 1B and three modes of switching between pairs of the rectifiers in accordance with embodiments of the present invention.

Figure 3 shows an isometric view of a nanowire crossbar array configured in accordance with embodiments of the present invention.

Figure 4 shows an isometric view of a nanowire crossbar revealing switches located at intersection of a crossbar configured in accordance with embodiments of the present invention.

Figure 5A shows an isometric view of four separate switches configured to demonstrate the role oxygen vacancies play in switches in accordance with embodiments of the present invention.

Figure 5B shows a plot of current-versus-voltage curves associated with switches shown in Figure 5A in accordance with embodiments of the present invention.

Figure 6 shows an isometric view of a switch configured in accordance with embodiments of the present invention.

Figures 7A-7C shows experimental results obtained from shunting switching a $Pt/TiO_2/Pt$ switch in accordance with embodiments of the present invention.

Figures 8A-8C represent experimental results obtained from opening switching a $Pt/TiO_2/Pt$ switch in accordance with embodiments of the present invention.

Figures 9A-9C represent experimental results obtained from inverting switching a $Pt/TiO_2/Pt$ switch in accordance with embodiments of the present invention.

DETAILED DESCRIPTION

Various embodiments of the present invention are directed to nanoscale, two-terminal, electronic switches, which are nonvolatile and combine reconfigurable diode rectifying states with memristive switching. A switch configured in accordance with embodiments of the present invention is composed of an active region sandwiched between two electrodes. The two interfaces between the active region and the electrodes are Schottky contacts. The active region is a diode that can be switched into one of four different rectifying states by applying an electrical field of an appropriate magnitude and polarity across the active region. The electric field changes the Schottky contacts at the interfaces to have Ohmic-like barriers and/or Schottky-like barriers, thus enabling the active region to be configured and the switch to operate as one of the four types of rectifiers: a forward rectifier, a reverse rectifier, a shunted rectifier, and a head-to-head rectifier. The active region remains in a particular rectifying state provided operating voltages applied to the switch do not exceed the magnitude of the electric field used to switch the rectifying state of the active region.

The detailed description is organized as follows. A description of two-terminal electronically actuated switches is provided in a first subsection. A description of switching the rectifying state of the switches is provided in a second subsection. Various materials that can be used to fabricate the switches are provided in a third subsection. Implementing the switches in crossbar arrays is provided in a fourth subsection. Finally, a switch composed of platinum electrodes and a $TiO_2$ active region is described in a fifth subsection.

I. A Two-terminal Electronically Actuated Switch

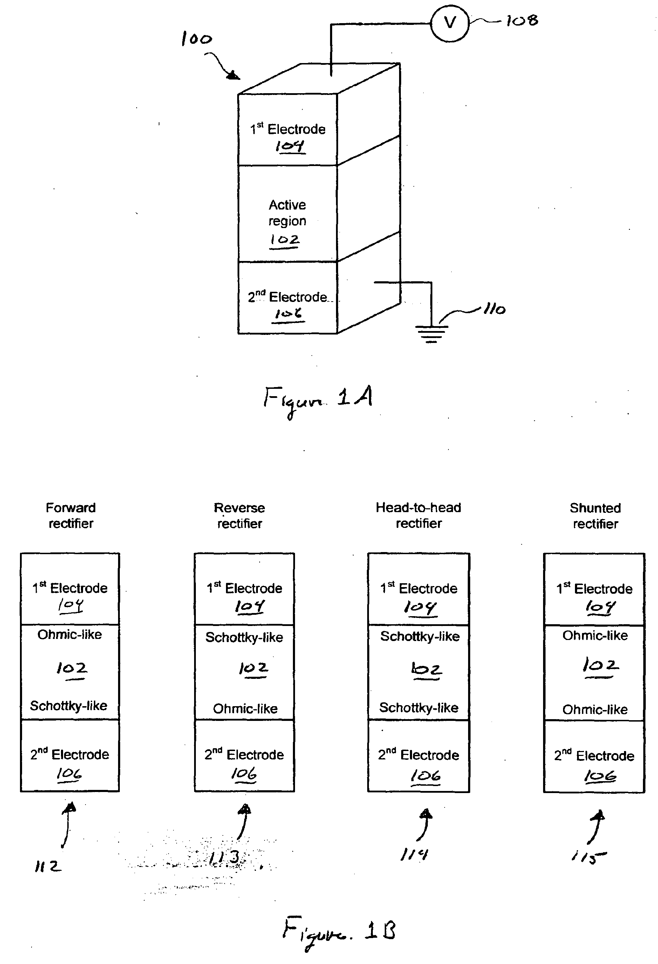

Figure 1A shows a two-terminal switch 100 configured in accordance with embodiments of the present invention. The switch 100 is composed of three layers: an active region 102 sandwiched between a first electrode 104 and a second electrode 106. The first electrode 104 is connected to a voltage source 108 and the second electrode is connected to a ground 110. The active region 102 is a diode that includes a dopant. Applying an electric field of an appropriate magnitude and polarity changes the position of the dopant. As a result, the active region 102 can be operated as one of the four different types of rectifiers: a forward rectifier, a reverse rectifier, a head-to-head rectifier, and a shunted rectifier.

The active region 102 is composed of a primary active region, or layer, and a secondary active region, or layer. The primary active region comprises a thin film of a material that is electornically semiconducting or nominally electronically insulating and can also be a weakly ionic conductor. The primary active material is capable of tranporting and hosting ions that act as dopants to control the flow of electrons through the switch 100. The basic mode of operation is to apply an electrical field of an appropriate magnitude and polarity across the active region 102. When the magnitude of the electrical field, also called a "drift field," exceeds some threshold for enabling the motion of the dopants in the primary material the dopant can drift into or out of the primary material via ionic transport. The ionic species are specifically chosen from those that act as electrical dopants for the primary material, and thereby change the rectifying state of the primary active material. For example, a rectifier can be changed from low conductivity (i.e, an undoped semiconductor or insulator - switch "off" configuration) to high conductivity (doped to provide a higher conductivity - switch "on" configuration) or from high conductivity to low conductivity (switch "on" to switch "off"). In addition, the primary active material and the dopants are chosen such that the drift of the dopants into or out of the primary active material is possible but not too facile in order to ensure that the active region 102 remains in a particular rectifying state for a reasonable period of time, perhaps for many years at room temperature. This ensures that the active region 102 is nonvolatile. In other words, the active region 102 is memristive (i.e., memory resistive) and holds its rectifying state after the drift field has been removed. Applying a drift field with a large enough magnitude causes both electron current and dopant to drift, whereas applying biases with lower relative voltage magnitudes than the drift field causes neglible dopant drift enabling the switch to hold its rectifying state.

On the other hand, the secondary active material comprises a thin film that is a source of dopants for the primary active material. These dopants may be impurity atoms such as hydrogen or some other cation, such as alkali or transition metals, that act as electron donors for the primary active material. Alternatively, the dopants can be anion vacancies, which in the primary active material are charged and therefore are also electron donors for the lattice. It is also possible to drive the anions into the primary active material, which become electon acceptors or hole donors.

The primary active material can be nanocrystalline, nanoporous, or amorphous. The mobility of the dopants in such nanostructured materials is much higher than in bulk crystalline material, since diffusion can occur through grain boundaries, pores or through local structural imperfections in an amorphous material. Also, because the primary active material film is thin, the amount of time needed for dopants to diffuse into or out of region of the film to substantially change the film's conductivety is relatively rapid. For example, the time needed for a diffusive process varies as the square of the distance convered, so the time to diffuse one nanometer is one-millionth the time to diffuse one micrometer.

The primary active and secondary active materials of the active region 102 are contacted on either side by metal electrodes 104 and 106, or one of the electrodes can be composed of a semiconductor material and the other a metal. When the active region 102 is composed of semiconductor material, the contract between a metal electrode and the active region 102 depletes the active region 102 of free charge carriers. Thus, the active region 102 has a net charge that depends on the indentity of the dopant which is positive in the case of electron donors and negative in the case of electron acceptors. The traditional description of electrode/semiconductor Schottky and Ohmic barriers is modified by the fact that the materials are structured at the nanoscale, and so the structural and electronic properties are not averaged over the large distances over which the theory of metal-semiconductor contracts have been developed. Thus, the undoped electrode/active region interfaces electronically resemble Schottky barriers and are called "Schottky-like barriers," and the doped electrode/semiconductor interfaces electronically resemble Ohmic barriers and are called "Ohmic-like barriers."

Conduction of electrons through the primary active material is via quantum mechanical tunneling through the Ohmic-like barrier. When the semiconducting material has a low dopant concentraion or is essentially intrinsic, the tunneling barrier is a Schottky-like barrier, which is high and wide. Thus, the conductivity through the switching material 102 is low and the device 100 is in the "off" state. When a significant number of dopants have been injected into the semiconductor, the tunneling barrier is an Ohmic-like barrier and the width and perhaps the height of the tunneling barrier are dimished by the potential of the dopants, which results in an increase in the conductivity, and the device 100 is in the "on" state.

Each of the four rectifiers has a different dopant arrangement. When the dopant is located at or near an electrode/active region interface, the interface has an Ohmic-like barrier. Thus, charge carriers can readily tunnel through the Ohmic-like barrier into and out of the active region 102. On the other hand, an undoped portion of the active region 102 at or near an electrode/active region interface has a Schottky-like barrier that is either too high or wide to permit most charge carriers from tunneling through the active region 102. Figure 1B shows the relative locations of the Ohmic-like and Schottky-like barriers associated with each of the four rectifiers in accordance with embodiments of the present invention. A forward rectifier 112 and a reverse rectifier 113 have Ohmic-like barriers and Schottky-like barriers located at opposite interfaces. A head-to-head rectifier 114 is characterized by having the dopants distributed within the active region 102 leaving Schottky-like barriers at both interfaces. On the other hand, a shunted rectifier 115 is characterized by having dopants located at or near both interfaces creating Ohmic-like barriers at both interfaces.

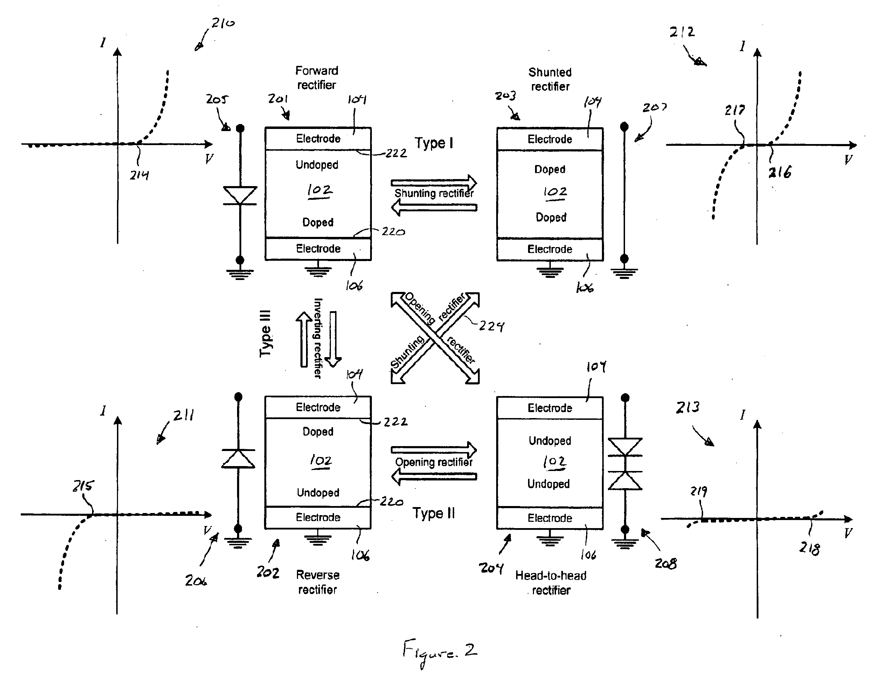

Switching from one rectifier to another can be accomplished by applying an electric field of an appropriate magnitude and polarity across the active region 102. The electric field forces the dopants to drift into or out of the electrode/active region interface regions thus changing.the rectifying state of the device 100. For example, as shown in Figure 1B, an appropriate electric field can be used to force dopants located near the interfaces of the shunted rectifier 115 to move to one of the interfaces thus changing the shunted rectifier 115 into either the forward rectifier 112 or the reverse rectifier 113. The current-versus-voltage (*I-V*) characteristic curves associated with each of the four rectifiers and switching from one rectifier to another is described in greater detail below with reference to Figure 2.

The ability of the charged species to diffuse into and out of the primary active material is substantially improved if one of the interfaces connecting the active region 102 to a metal or semiconductor electrode is non-covalently bonded. Such an interface may be caused by a void in the material or it may be the result of an interface that contains a material that does not form covalent bonds with the electrode, the primary active material, or both. This non-covalently bonded interface lowers the activation energy of the atomic rearrangements that are needed for drift of the dopants in the primary active material. This interface is essentially an extremely thin insulator, and adds very little to the total series resistance of the switch.

One potentially useful property of the primary active material is that it can be a weak ionic conductor. The definition of a weak ionic conductor depends on the application for which a switch 100 is designed. The mobility $\mu_d$ and diffusion constant D for a dopant in a lattice are directly proportional to one another as characterized by the Einstein relation:

$$D = \mu_d kT$$

where *k* is Boltzmann's constant, and *T* is absoulte temperature. Thus, if the mobility $\mu_d$ of a dopant in a lattice is high so is the diffusion constant *D*. In general, it is desired for the active region 102 of the switch 100 to maintain a particular rectifying state for an amount of time that may range from a fraction of a second to years, depending on the application. Thus, it is desired that the diffusion constant *D* be low enough to ensure a desired level of stability, in order to avoid inadvertently turning the active region 102 from one rectifier to another rectifier via ionized dopant diffusion, rather than by intentionally setting the state of the active region 102 with an appropriate voltage. Therefore, a weakly ionic conductor is one in which the dopant mobility $\mu_d$ and the diffusion constant *D* are small enough to ensure the stability or non-volatility of the active region 102 for as long as necessary under the desired conditions. On the other hand, strongly ionic conductors would have relatively larger dopant mobilities and be unstable against diffusion.

II. Non-volatile Memristive Switching of the Switch

The active region 102 is non-volatile and re-configurable and exhibits diode rectifying states with memristive switching. Figure 2 shows schematic profiles of the four rectifiers 201-204 of the active region 102 and three modes of switching between pairs of the rectifiers in accordance with embodiments of the present invention. In addition to the four rectifiers 201-204, Figure 2 includes circuit diagrams 205-208 and *I-V* characteristic plots 210-213 that are associated with each of the four rectifiers 201-204. As shown in Figure 2, each of the four rectifiers 201-204 of the switch 100 represents a different profile distribution of dopants, and therefore, has a different associated *I-V* characteristic represented in each of the plots 210-213. Electrode/active region contacts are typically Ohmic-like in the case of heavy doping, and rectifying or Schottky-like in the case of low doping. Thus, the concentration of dopants at an interface determines the electrical behavior, and therefore, the transport of electrons through the switch 100. In Figure 2, the four different rectifiers 201-204 are indentified as a forward rectifier, a reverse rectifier, a shunted rectifier, and a head-to-head rectifier, respectively. The rectifying state properties of each of these rectifiers depend on the distribution of dopants within the active region 102.

The plots 210-213 of the *I-V* characteristic curves reveal the response of the switch 100 to different voltage polarities and magnitudes. In particular, plot 210 reveals that when the switch 100 is configured as the forward rectifier 201, current flows from the first electrode 104 to the second electrode for positive polarity voltages exceeding a voltage 214 and resistance is large for negative polarity voltages. Plot 211 reveals that when the switch 100 is configured as the reverse rectifier 202, current flows from the second electrode 106 to the first electrode 104 for negative polarity voltages exceeding a voltage 215 and resistance is large for positive polarity voltages. Plot 212 reveals that when the switch 100 is configured as the shunted rectifier 203, current substantially flows undisturbed through the switch 100 for positive and negative polarity voltages with magnitudes exceeding voltages 216 and 217. Finally, plot 213 reveals that when the switch 100 is configured as a head-to-head rectifier 204, the resistance of the switch 100 is high for positive and negative polarity voltages between voltages 218 and 219. Note that plots 210-213 show only operating voltage ranges. In other words, the magnitudes of voltages applied to the rectifiers 201-204 represented in plots 210-213 are not large enough to change the rectifier to a different rectifier or destroy the switch 100.

The dopants are mobile under an appropriate drift field because the active region 102 may only be a few nanometers thick. The reconfiguration of the dopant profiles due to the drift of dopants under a drift field leads to electrical switching between the four rectifiers. As shown in Figure 2, shunting is switching between the forward rectifier 201 and the shunted rectifier 203. In this switching, interface 220 is heavily doped and remains Ohmic-like with negligible changes during the electrical biasing. A bias with an appropriate polarity and magnitude on the first electrode 104 attracts a portion of the dopants to the interface 222, switching the device from the forward rectifier 201 to the shunted rectifier 203. A bias with an opposite polarity and approximately the same magnitude switches the shunted rectifier 203 back to the forward rectifier 201. Of course, the switching between the reverse rectifier 202 and the shunted rectifier 203 also belongs to this type of switching, indicated by diagonal arrow 224.

Opening is switching between the reverse rectifier 202 and the head-to-head rectifier 204. In this case, the undoped interface 220 remains unchanged and only the doped interface 222 is switched. The undoped interface contains few dopants and remains rectifying instead of Ohmic-like. A bias of an appropriate polarity and magnitude on the first electrode 104 forces dopants away from the interface 222 and switches the reverse rectifier 202 into the head-to-head rectifier 204, and vice versa. The switching between the forward rectifier 201 and the back-to-back rectifier 204 is also opening.

Inverting between the forward rectifier 201 and the reverse rectifier 202 involves simultaneously applying oppositely polarized biases to the electrodes 104 and 106. For example, switching from the forward rectifier 201 to the reverse rectifier 202 is accomplished by applying oppositely polarized biases to the electrodes 104 and 106 to forces dopants away from the interface 220 and at the same time attracts dopants to the interface 222. Switching from the reverse rectifier 202 to the forward rectifier 201 is accomplished by applying oppositely polarized biases to the electrodes 104 and 106 to force dopants away from the interface 222 and at the same time attract dopants to the interface 220. Therefore, the dopant profile across the active region 102 is essentially inverted and so is the rectifying orientation, resulting in a switching between a reverse rectifier and a forward rectifier.

III. Active Region Materials

The electrodes 104 and 106 can be composed of platinum, gold, silver, copper, or any other suitable metal, metallic compound (e.g. some perovskites such as $BaTiO_3$ and $Ba_{1-x}La_xTiO_3$) or semiconductor. The primary and secondary active materials of the active region 102 can be oxides, sulfides, selenides, nitrides, phosphides, arsenides, chlorides, and bromides of the transition and rare earth metals, with or without the alkaline earth metals being present. In addition, there are various alloys of these compounds with each other, which can have a wide range of compositions if they are mutually soluble in each other. In addition, the active region 102 can be composed of mixed compounds, in which there are two or more metal atoms combined with some number of electronegative elements. The dopants can be anion vacancies or different valence elements doped in the active region 102. One combination of materials is a primary active material that is undoped and stoichiometric, and thus a good insulator, combined with a secondary source/sink of the same or related parent material that either contains a large concentration of anion vacancies or other dopants that can drift into the primary material under the application of an appropriate bias.

The active region 102 can be composed of oxides that contain at least one oxygen atom (O) and at least one other element. In particular, the active region 102 can be composed of titania ($TiO_2$), zirconia ($ZrO_2$), and hafnia ($HfO_2$). These materials are compatible with silicon (Si) integrated circuit technology because they do not create doping in the Si. Other embodiments for the active region 102 include alloys of these oxides in pairs or with all three of the elements Ti, Zr, and Hf present. For example, the active region 102 can be composed of $Ti_xZr_yHf_zO_2$, where $x + y + z = 1$. Related compounds include titanates, zirconates, and hafnates. For example, titanates includes $ATiO_3$, where A represents one of the divalent elements strontium (Sr), barium (Ba) calcium (Ca), magnesium (Mg), zinc (Zn), and cadmium (Cd). In general, the active region 102 can be composed of $ABO_3$, where A represents a divalent element and B represents Ti, Zr, and Hf. The active region 102 can also be composed of alloys of these various compounds, such as $Ca_aSr_bBa_cTi_xZr_yHf_zO_3$, where $a + b + c = 1$ 1 and $x + y + z = 1$. There are also a wide variety of other oxides of the transition and rare earth metals with different valences that may be used, both individually and as more complex compounds. In each case, the mobile dopant can be an oxygen vacancy or an aliovalent element doped into the active region 102. The oxygen vacancies effectively act as dopants with one shallow and one deep energy level. Because even a relatively minor nonstoichiometry of about 0.1% oxygen vacancies in $TiO_{2-x}$ is approximately equivalent to $5 \times 10^{19}$ dopants/cm$^3$, modulating oxygen vacancy profiles have strong effect on electron transport.

In other embodiments, the active region 102 can be a sulfide or a selenide of the transition metals with some ionic bonding character, essentially the sulfide and selenide analogues of the oxides described above.

In other embodiments, the active region 102 can be a semiconducting nitride or a semiconducting halide. For example, semiconducting nitrides include AlN, GaN, ScN, YN, LaN, rare earth nitrides, and alloys of these compounds and more complex mixed metal nitrides, and semiconducting halides include CuCl, CuBr, and AgCl. The active region 102 can be a phosphide or an arsenide of various transition and rare earth metals. In all of these compounds, the mobile dopant can be an anion vacancy or an aliovalent element.

A variety of dopants can be used and are selected from a group consisting of hydrogen, alkali, and alkaline earth cations, transition metal cations, rare earth cations, oxygen anions or vacancies, chalcogenide anions or vacancies, nitrogen anions or vacancies, pnictide anions or vacancies, or halide anions or vacancies.

Table. Exemplary List of Doped, Undoped, and Mobile Dopants Composing Compound Materials.

| Undoped | Doped | Mobile Dopant |
|---|---|---|
| $TiO_2$ | $TiO_{2-x}$ | Oxygen vacancies |
| $ZrO_2$ | $ZrO_{2-x}$ | Oxygen vacancies |
| $HfO_2$ | $HfO_{2-x}$ | Oxygen vacancies |
| $SrTiO_2$ | $SrTiO_{2-x}$ | Oxygen vacancies |
| GaN | $GaN_{1-x}$ | Nitrogen vacancies |
| CuCl | $CuCl_{1-x}$ | Chlorine vacancies |
| GaN | GaN:S | Sulfide ions |

In other embodiments, the active region 102 can also be composed of a wide variety of semiconductor materials including various combinations of direct and indirect semiconductors. A direct semiconductor is characterized by the valence band maximum and the conduction band minimum occurring at the same wavenumber. In contrast, indirect semiconductors are characterized by the valence band maximum and the conduction band minimum occurring at different wavenumbers. The indirect and direct semiconductors can be elemental and compound semiconductors. Indirect elemental semiconductors include Si and germanium (Ge), and compound semiconductors include III-V materials, where Roman numerals III and V represent elements in the IIIa and Va columns of the Periodic Table of the Elements. Compound semiconductors can be composed of column IIIa elements, such as aluminum (Al), gallium (Ga), and indium (In), in combination with column Va elements, such as nitrogen (N), phosphorus (P), arsenic (As), and antimony (Sb). Compound semiconductors can also be further classified according to the relative quantities of III and V elements. For example, binary semiconductor compounds include semiconductors with empirical formulas GaAs, InP, InAs, and GaP; ternary compound semiconductors include semiconductors with empirical formula $GaAs_yP_{1-y}$, where $y$ ranges from greater than 0 to less than 1; and quaternary compound semiconductors include semiconductors with empirical formula $In_xGa_{1-x}As_yP_{1-y}$, where both $x$ and $y$ independently range from greater than 0 to less than 1. Other types of suitable compound semiconductors include II-VI materials, where II and VI represent elements in the IIb and VIa columns of the periodic table. For example, CdSe, ZnSe, ZnS, and ZnO are empirical formulas of exemplary binary II-VI compound semiconductors.

The dopants can be p-type impurities, which are atoms that introduce vacant electronic energy levels called "holes" to the electronic band gaps of the active region 102. These impurities are also called "electron acceptors." The dopants can be n-type impurities, which are atoms that introduce filled electronic energy levels to the electronic band gap of the active region 102. These impurities are called "electron donors." For example, boron (B), Al, and Ga are p-type impurities that introduce vacant electronic energy levels near the valence band of Si; and P, As, and Sb are n-type impurities that introduce filled electronic energy levels near the conduction band of Si. In III-V compound semiconductors, column VI impurities substitute for column V sites in the III-V lattice and serve as n-type impurities, and column II impurities substitute for column III atoms in the III-V lattice to form p-type impurities. Moderate doping of the active region 102 can have impurity concentrations in excess of about $10^{15}$ impurities/cm$^3$ while more heavy doping of the active region 102 can have impurity concentrations in excess of about $10^{19}$ impurities/cm$^3$.

IV. Nanowire Implementations

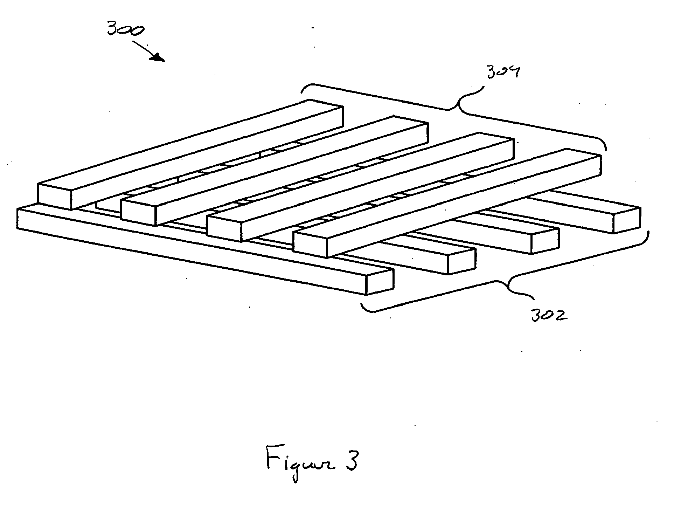

The switch 100 can be implemented at nanowire intersections of nanowire crossbar arrays. Figure 3 shows an isometric view of a nanowire crossbar array 300 configured in accordance with embodiments of the present invention. The crossbar array 300 is composed of a first layer of approximately parallel nanowires 302 that are overlain by a second layer of approximately parallel nanowires 304. The nanowires of the second layer 304 are roughly perpendicular, in orientation, to the nanowires of the first layer 302, although the orientation angle between the layers may vary. The two layers of nanowires form a lattice, or crossbar, each nanowire of the second layer 304 overlying all of the nanowires of the first layer 302 and coming into close contact with each nanowire of the first layer 302 at nanowire intersections that represent the closest contact between two nanowires.

Although individual nanowires in Figure 3 are shown with rectangular cross sections, nanowires can also have square, circular, elliptical, or more complex cross sections. The nanowires may also have many different widths or diameters and aspect ratios or eccentricities. The term "nanowire crossbar" may refer to crossbars having one or more layers of sub-microscale wires, microscale wires, or wires with larger dimensions, in addition to nanowires.

The layers can be fabricated by mechanical nanoimprinting techniques. Alternatively, nanowires can be chemically synthesized and can be deposited as layers of approximately parallel nanowires in one or more processing steps, including Langmuir-Blodgett processes. Other alternative techniques for fabricating nanowires may also be employed. Thus, a two-layer nanowire crossbar comprising first and second layers, as shown in Figure 3, can be manufactured by any of numerous relatively straightforward processes. Many different types of conductive and semi-conductive nanowires can be chemically synthesized from metallic and semiconductor substances, from combinations of these types of substances, and from other types of substances. A nanowire crossbar may be connected to microscale address-wire leads or other electronic leads, through a variety of different methods in order to incorporate the nanowires into electrical circuits. At nanowire intersections, nanoscale electronic components, such as resistors, and other familiar basic electronic components, can be fabricated to interconnect two overlapping nanowires. Any two nanowires connected by a switch is called a "crossbar junction."

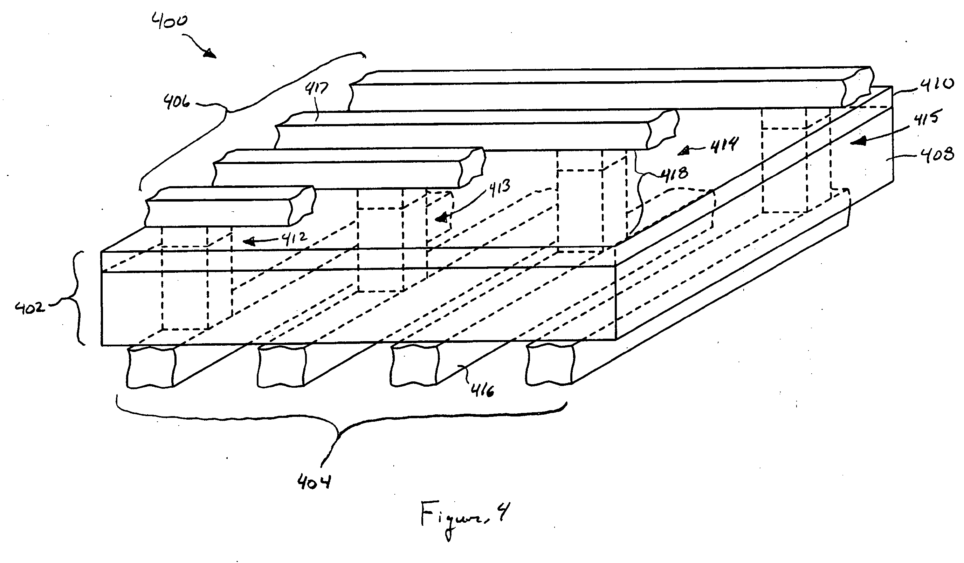

Figure 4 shows an isometric view of a nanowire crossbar 400 revealing an intermediate layer 402 disposed between a first layer of approximately parallel nanowires 404 and a second layer of approximately parallel nanowires 406 in accordance with embodiments of the present invention. The layer 402 is composed of sub-layers 408 and 410. The sub-layer 408 can be composed of an undoped material, and the sub-layer 410 can be composed of a doped material, respectively. The material comprising the layer 402 and dopants are selected as described in subsection III to form switches 412-415 at each nanowire intersection. The nanowires can be composed of suitable metal of semiconductor materials and serve as electrodes. For example, sub-layer 408 can be composed of $TiO_2$, relatively thinner sub-layer 410 can be composed of $TriO_{2-x}$, where oxygen vacancies in the sub-layer 410 are dopants, and the nanowires can be composed of Pt. The switch 414 is formed by a nanowire 416 in the first layer 404, a nanowire 417 in the second layer 406, and a region 418 within the layer 402 between the nanowires 416 and 417. Each of the switches 412-415 can be operated separately to produce the forward, reverse, shunted, and head-to-head rectifiers described above with reference to Figure 2.

V. Examples

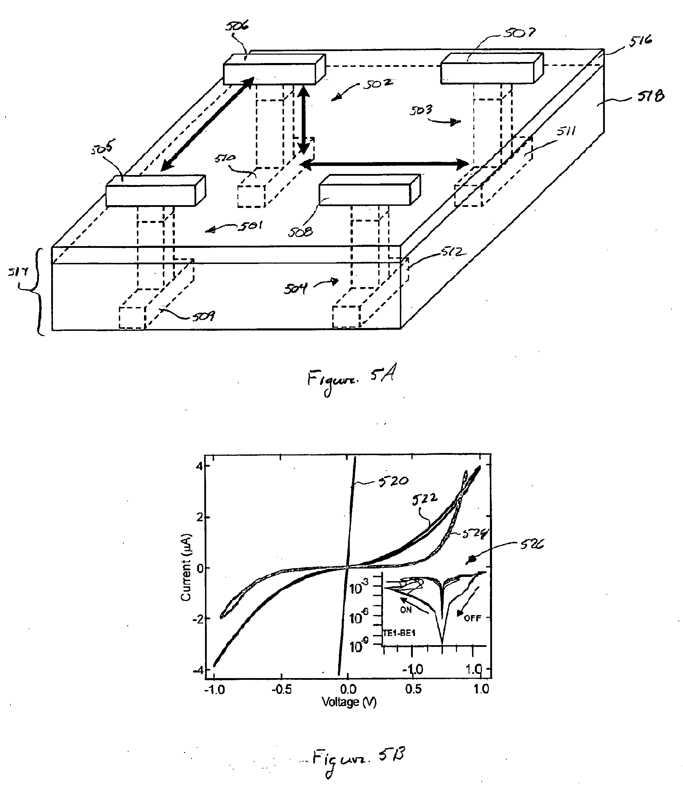

Oxygen vacancies in $TiO_2$ operate as n-type dopants transforming a wide bandgap oxide into a material that operates as an electrically conductive doped semiconductor. As described above with reference to Figure 2, the dopant concentration at the two interfaces of the switch 100 play a crucial role in configuring the switch 100 to operate as one of the four rectifiers. Figure 5A shows an isometric view of four separate switches 501-504 configured to demonstrate the role oxygen vacancies play in modulating the properties of the interfaces in accordance with embodiments of the present invention. Modulating the oxygen vacancies in turn controls the flow of electrons through a crossbar junction. The switching elements 501-504 of Figure 5 consist of Pt first electrodes 505-508 and Pt second electrodes 509-512 separated vertically by a titanium dioxide layer 514. The first electrode pairs 505-506 and 507-508 are separated by approximately 1 mm, and the second electrode pairs 510-511 and 509-512 are also separated by approximately 1 mm. The titanium dioxide layer 514 is a bi-layer consisting of a thin, approximately 4 nm thick, $TiO_2$ layer 516 with few oxygen vacancies and a thicker, approximately 120 nm thick, $TiO_{2-x}$ layer 518 with many more

oxygen vacancies. The $TiO_{2-x}$ layer is an n-type semiconductor with a carrier concentration of about $10^{19}$ cm$^{-3}$ obtained from Hall measurement, and the $TiO_2$ layer is nearly stoichiometric.

Any pair of electrodes 505-512 form a switch, from which an *I-V* curve can be obtained, as shown in Figure 5B. *I-V* curve 520 corresponds to second electrodes 510 and 511 and reveals two Ohmic-like barriers at the Pt/$TiO_{2-x}$ interfaces. The fact that the resistance between electrodes 510 and 511 is low indicates that the bulk oxide is conductive. In contrast, *I-V* curve 522 corresponds to electron transmission between the two first electrodes 505 and 506 and is symmetric and nonlinear, revealing two Schottky-like barriers at the Pt/$TiO_2$ interfaces. Much lower current for the *I-V* curve 522 than that of the *I-V* curve 520 suggests that it is the Schottky-like interfaces that dominate the transmission of electrons through the switches since the bulk resistances are essentially the same for these two cases. A rectifying *I-V* curve 524 corresponds to electrodes 506 and 510 and is consistent with the fact that the corresponding device has a Schottky-like barrier at the Pt/$TiO_2$ interfaces and an Ohmic-like barrier at the PUTiO$_{2-x}$ interfaces. One explanation as to why the current level between first and second electrodes 506 and 510 is lower than that of the first electrodes 505 and 506 is due to the much smaller effective junction surface area in the former case. An inset 526 in Figure 5B is the log-scale *I-V* data showing reversible switching behavior of the switch formed between first and second electrodes 506 and 510.

The initial resistance state of the switches, i.e. the oxygen vacancy profile, in large degree determines the rectifying state of the switch. In practice, the oxygen vacancy profile can be controlled by engineering the structure and/or the fabrication condition of the active region, such as deposition gas species, annealing environment, inserting pure metal (e.g., Ti) at the interface. The following description provides results representing the realization of all three types of switching in real switches.

Circuit models accompanying the following experimental results include memristors. The term "memristor" is short for "memory resistor." Memristors are a class of passive two-terminal circuit elements that maintain a functional relationship between the time integrals of current and voltage. This results in resistance varying according to the device's memristance function. Specifically engineered memristors provide controllable resistance useful for switching current. The memristor is a special case in so-called "memristive systems," a class of mathematical models useful for certain empirically observed phenomena, such as the firing of neurons. The definition of the memristor is based solely on fundamental circuit variables, similar to the resistor, capacitor, and inductor. Unlike those more familiar elements, the necessarily nonlinear memristors may be described by any of a variety of time-varying functions. As a result, memristors do not belong to Linear Time-Independent circuit models. A linear time-*in*variant memristor is simply a conventional resistor.

The memristor is formally defined as a two-terminal element in which the magnetic flux $\Phi_m$ between the terminals is a function of the amount of electric charge q that has passed through the device. Each memristor is characterized by its memristance function describing the charge-dependent rate of change of flux with charge as follows:

$$M(q) = \frac{d\Phi_m}{dq}$$

Based on Faraday's law of induction that magnetic flux $\Phi_m$ is the time integral of voltage, and charge q is the time integral of current, the memristance can be written as

$$M(q) = \frac{V}{I}$$

Thus, the memristance is simply charge-dependent resistance. When $M(q)$ is constant, the memristance reduces to Ohm's Law $R = V/I$. When $M(q)$ is not constant, the equation is not equivalent because q and $M(q)$ vary with time. Solving for voltage as a function of time gives:

$$V(t) = M(q(t))I(t)$$

This equation reveals that memristance defines a linear relationship between current and voltage, as long as charge does not vary. However, nonzero current implies instantaneously varying charge. Alternating current may reveal the linear dependence in circuit operation by inducing a measurable voltage without net charge movement, as long as the maximum change in q does not cause change in M. Furthermore, the memristor is static when no current is applied. When $I(t)$ and $V(t)$ are 0, $M(t)$ is constant. This is the essence of the memory effect.

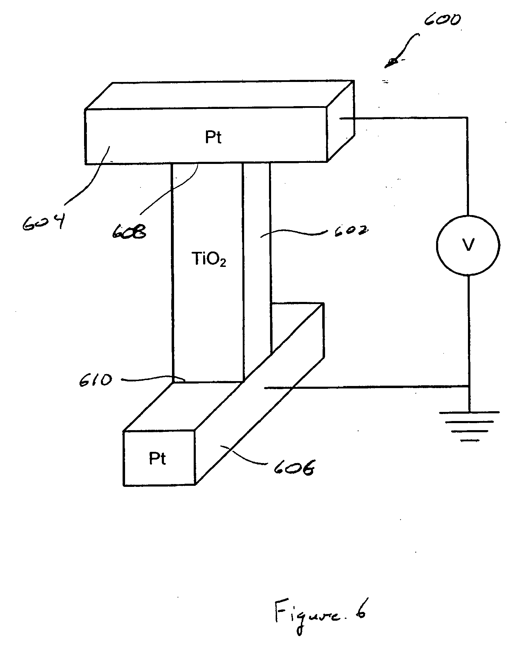

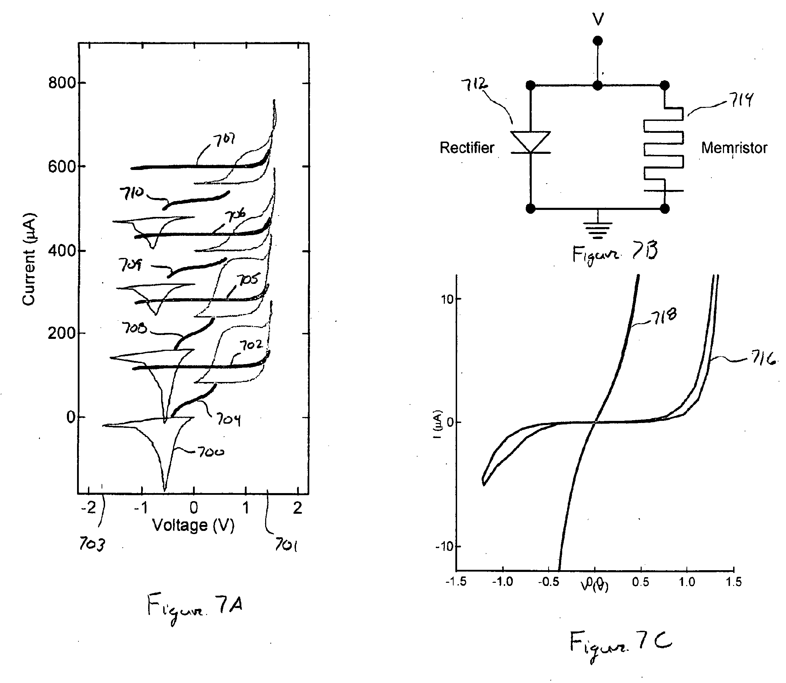

Figure 6 shows an isometric view of a general representation of a switch 600 representing used to obtain the experimental results described below with reference to Figures 7-9 and is provided as a reference in describing the results presented in Figures 7-9. As shown in Figure 6, the switch 600 comprises a $TiO_2$ active region 602 disposed between a crossing point of a Pt first electrode 604 and a Pt second electrode 606. The switch 600 was fabricated to have asymmetric oxygen vacancy concentrations at first interface 608 and second interface 610. In performing the electrical measurements, the second electrode 606 was grounded.

Figures 7-9 present experimental results corresponding to shunting, opening, and inverting switching in accordance with embodiments of the present invention for a Pt/TiO$_2$/Pt switch represented by the switch 600. In Figures 7-9, loops, such as loop 700 in Figure 7A, represent negative and positive switching voltage sweeps. After each switching voltage sweep, a checking *I-V* was taken to measure the rectifying state of the device after switching.

Figures 7A-7C represent experimental results obtained from shunting switching an approximately 50x50 nm$^2$ Pt/TiO$_2$/Pt switch in accordance with embodiments of the present invention. The first interface 608 has fewer oxygen vacancies than the second interface 610, which remains Ohmic-like during switching. The active part is the first interface 608, which governs the electron transport of the switch 600. In Figure 7A, a positive bias of about 1.4 V 701 applied to the first electrode 604 drives the oxygen vacancies from the first interface 608 toward the second interface 610 and switches the device "off." The switch 600 in the "off" state is characterized by rectifying *I-V* curve 702, in Figure 7A. A negative bias of approximately -1.8 V 703 applied to the first electrode 608 attracts the oxygen vacancies to the first interface 608, shunts the rectifier at the first interface 608, and switches the device to a higher conductance state characterized by *I-V* curve 704. Depending on the length and magnitude of the bias, the device can actually be switched to multiple "on" states represented by *I-V* curves 705-707 and multiple "off" states represented by *I-V* curves 708-710. Comparing with the first two "on" negative voltage sweeps, the last two "on" sweeps actually switch the device to a less conductive "on" states represented by *I-V* curves 709 and 710 in Figure 7A.

Figure 7B shows a circuit diagram representing the switching behavior of the switch during shunting switching in accordance with embodiments of the present invention. In the circuit diagram of Figure 7B, a rectifier 712 is in parallel to a memristor 714, whose polarity is indicated by a bar on one end. A positive bias applied to the end of the memristor 714 with the bar switches the memristor 714 "on," shunting the rectifier 712. An opposite bias switches the memristor 714 "off," recovering the rectifier 712. The "on/off" conductance ratio is found to be about 10$^3$ for both microscale and nanoscale devices, while the nanoscale devices can be operated at about 100 times a lower current level than that of the microscale devices.

Figure 7C shows a plot of *I-V* curves corresponding to shunting switching in accordance with embodiments of the present invention. *I-V* curve 716 corresponds to the switch in the "off" state, and *I-V* curve 718 corresponds to the switch in the "on" state.

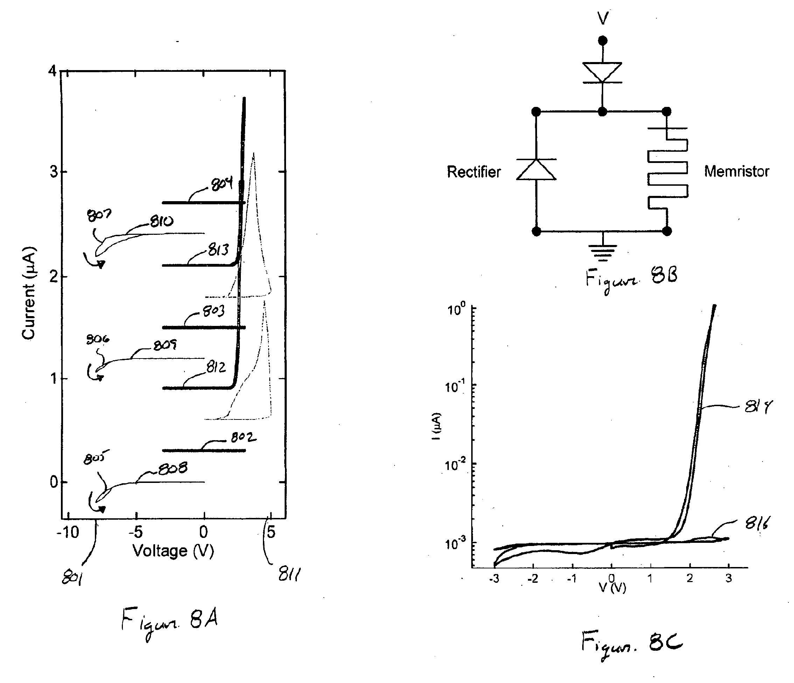

Figures 8A-8C represent experimental results obtained from opening switching of an approximately 5x5 μm$^2$ Pt/TiO$_2$/Pt switch in accordance with embodiments of the present invention. Figure 8A shows a plot of the results for the opening switching. The two interfaces 608 and 610 have asymmetric dopant distribution. The more resistive first interface 608 (exposed to air for further oxidation before depositing the top electrode) remains Schottky-like or rectifying during switching and the active part is the second interface 610. A negative voltage bias of about -8 V 801 from the first electrode 604 to the second electrode 606 drives positively charged oxygen vacancies away from the second interface interface 610 and switches the device "off." The *I-V* curves 802-804 reveal that the "off" state is resistive. There are small loops 805-807 with a counterclockwise directions in the "off" sweep curves 808-810, reflecting a tiny "on" switching for the first interface 608 during the greater "off" switching of the second interface 610. An opposite bias of about 5 V 811 switches the second interface 610 into an Ohmic-like barrier and the electrical transport of the device is limited only by the rectifying first interface 608, producing rectifying *I-V* curve 812 and 813 for the "on" state.

Figure 8B shows a circuit diagram representing the switching behavior of the switch during opening switching in accordance with embodiments of the present invention. The equivalent circuit for this *opening* switching is similar to that for *Shunting* switching except that an intrinsic rectifier is added in series, which appears to be an efficient means for adding a diode to each crossbar intersection memory cell in order to limit cross talk in a memory architecture. In addition, the operating power is low for this type of device. A 10$^{-9}$ A current level can be expected for nanoscale devices based on the 10$^{-6}$ A current used to switch the micro-scale device in Fig. 4B and the scalability observed in this device. This type of switching also exhibits a high reproducibility.

Figure 8C shows a plot of *I-V* curves corresponding to opening switching in accordance with embodiments of the present invention. A log-scale of the *I-V* curves for both "on" and "off" states are shown in Figure 8C, exhibiting a roughly 10$^3$ conductance ratio. *I-V* curve 814 corresponds to "on" state and *I-V* curve 816 corresponds to the "off" state.

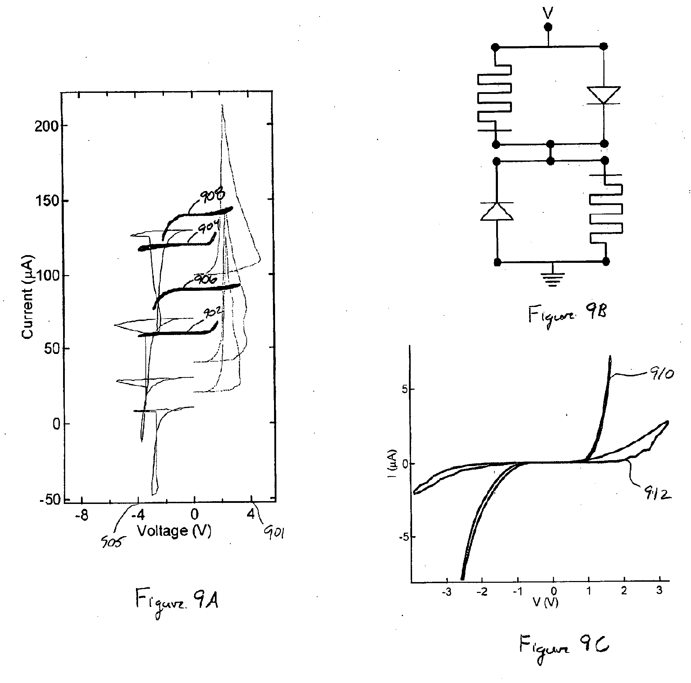

Figures 9A-9C represent experimental results obtained from inverting switching of an approximately 50x50 nm$^2$ Pt/TiO$_2$/Pt switch in accordance with embodiments of the present invention. Figure 9A shows a plot of the results for the inverting switching. The distribution of oxygen vacancies within the active region 602 is symmetric and the oxygen vacancies changes at the two interfaces 608 and 610 takes place at approximately the same time but in opposite directions. When a positive bias about 4 V 901 is applied to the first electrode 604, oxygen vacancies are driven away from the first interface 608 and attracted to the second interface 610, resulting in more oxygen vacancies at the second interface 610 than at the first interface 608. The switch is switched to a rectifying state with a certain rectifying direction as shown by the checking *I-V* curves 902 and 904. Applying a negative bias of about -4 V 905 reverses the oxygen vacancy profile across the active region 602 and switches the switch to a resistive state with an opposite rectifying direction, which is represented by *I-V* curves 906 and 908.

Figure 9B shows a circuit diagram representing the switching behavior of the switch during inverting switching in accordance with embodiments of the present invention. The circuit diagram reveals that inverting switching can be accomplished by including two head-to-head shunting switches in series, as shown in Figure 7B.

Figure 9C shows a plot of *I-V* curves corresponding to inverting switching in accordance with embodiments of the present invention. *I-V* curves 910 and 912 represent the forward and reverse rectifying states, respectively.

An oxygen vacancy is the only dopant used for the concept demonstration of the three the switching types described above. However, in principle, other dopants (e.g., C and N) with different properties, such as mobility, charge, and diffusivity, can be introduced to the system to intestinally build an asymmetric device. Only one dopant like oxygen vacancies can be sufficient for the inverting switch since the device is symmetric and equal but opposite changes at the two interfaces are needed for this type of switching. As for opening and shunting switching, one interface is heavily reduced for shunting or oxidized for opening in order to minimize the change at that interface during switching. A different dopant that is much less mobile than oxygen vacancies at the unchanged interface would serve that purpose even better.

## Claims

1.  An electronic switch (100) comprising:

    a first electrode (104);
    a second electrode (106); and
    an active region (102) disposed between the first electrode and the second electrode and including at least one dopant, **characterized in that** the switch can be re-configured to operate as a forward rectifier (112), a reverse rectifier (113), a head-to-head rectifier (114), or a shunted rectifier (115) by positioning the at least one dopant within the active region to control the flow of charge carriers through the switch.

2.  The switch of claim 1 wherein the active region (102) further comprises:

    at least one primary active region comprising at least one material for transporting the dopant that controls the flow of charge carriers through the switch; and
    a secondary active region comprising at least one material for providing a source/sink of the dopant for the at least one primary active region.

3.  The switch of claim 2 wherein the primary active region further comprises a material that is electronically semiconducting, nominally electronically insulating, or weakly ionic conducting.

4.  The switch of claim 2 wherein the at least one primary active region further comprises a film having an electrical conductivity that is capable of being reversibly changed from a relatively low conductivity to a relatively high conductivity as a function of dopants being injecting into or out of the at least one primary active region via drift.

5.  The switch of claim 2 wherein the at least one dopant of the secondary active region is selected to change the electrical conductivity of the at least one primary active region from a relatively low electrical conductivity to a relatively high electrical conductivity or from a relative high electrical conductivity to a relatively low conductivity.

6.  The switch of claim 5 wherein the dopant is selected from a group consisting of ionized interstitial or substitutional impurity atoms, cation donor species, anion vacancies, and anionic acceptor species.

7.  The switch of claim 6 wherein the dopant is selected from a group consisting of hydrogen, alkali and alkaline earth cations, transition metal cations, rare earth cations, oxygen anions or vacancies, chalcognenide anions or vacancies, nitrogen anions or vacancies, pnictide anions or vacancies, or halide anions or vacancies.

8.  The switch of claim 1 wherein the at least one material for the primary active region and the material for the secondary active region are selected from the groups consisting of:

    (1) oxides, sulfides, selenides, nitrides, phosphates, arsenides, and bromides of transition metals, rare earth metals, and alkaline earth metals;
    (2) alloys of like compounds from list (1) with each other; and
    (3) mixed compounds, in which there are at least two different metal atoms combined with at least one electronegative element.

9.  The switch of claim 8 wherein the at least one material for the primary active region and the material for the secondary active region are selected from the group consisting of titanates, zirconates, hafnates, alloys of these three oxides in pairs or with all three present together, and compounds of the type $ABO_3$, where A represents at least one divalent element and B represents at least one of titanium, zirconium, and hafnium.

**10.** The switch of claim 8 wherein the at least one material for the primary active region and the material for the secondary active region are selected from the following list:

TiO$_2$/ TiO$_{2-x}$;
ZrO$_2$/ ZrO$_{2-x}$;
HfO$_2$/ HfO$_{2-x}$;
SrTiO$_2$/ SrTiO$_{2-x}$;
GaN/ GaN$_{1-x}$;
CuCl/ CuCl$_{1-x}$; and
GaN/ GaN:S.

**11.** The switch of claim 1 wherein both electrodes are metal, metallic compounds, or one of the electrodes is metal and another of the electrodes is a semiconductor.

**12.** The switch of claim 1 wherein positioning the dopant within the active region further comprises applying a voltage of an appropriate magnitude and polarity that causes the dopant to drift into or away from particular regions of the active layer.

**13.** The switch of claim 1 wherein position the dopant near an electrode/active region interface makes the interface Ohmic-like and positioning the dopant away from an electrode/active region interface makes the interface Schottky-like.

**14.** A nanowire crossbar (300,400) comprising:

a first layer (302,404) of substantially parallel nanowires;
a second layer (304,406) substantially parallel nanowires overlaying the first layer of nanowires; and
at least one nanowire intersection (412-415) forming an electronic switch configured in accordance with claim 1.

**15.** The crossbar of claim 14 wherein any two nanowires in the first layer (505,506) form an electronic switch configured in accordance with claim 1 and any two nanowires in the second layer (510,511) form an electronic switch configured in accordance with claim 1.

**Patentansprüche**

**1.** Elektronischer Schalter (100), umfassend:

eine erste Elektrode (104);
eine zweite Elektrode (106); und
eine aktive Region (102), die zwischen der ersten Elektrode und der zweiten Elektrode angeordnet ist und zumindest einen Dotierstoff enthält, **dadurch gekennzeichnet, dass** der Schalter neu konfiguriert werden kann, um als Durchlassrichtung-Gleichrichter (112), Sperrrichtung-Gleichrichter (113), Head-to-Head-Gleichrichter (114) oder Nebenschluss-Gleichrichter (115) zu arbeiten, indem der zumindest eine Dotierstoff innerhalb der aktiven Region positioniert wird, um den Fluss von Ladungsträgern durch den Schalter zu steuern.

**2.** Der Schalter nach Anspruch 1, wobei die aktive Region (102) ferner umfasst:

zumindest eine primäre aktive Region, die zumindest ein Material zum Transportieren des Dotierstoffs umfasst, der den Fluss von Ladungsträgern durch den Schalter steuert; und eine sekundäre aktive Region, die zumindest ein Material zum Bereitstellen einer Quelle/Senke des Dotierstoffs für die zumindest eine primäre aktive Region umfasst.

**3.** Der Schalter nach Anspruch 2, wobei die primäre aktive Region ferner ein Material umfasst, das elektronisch halbleitend, nominell elektronisch isolierend oder schwach ionisch leitend ist.

**4.** Der Schalter nach Anspruch 2, wobei die zumindest eine primäre aktive Region ferner einen Film mit einer elektrischen Leitfähigkeit umfasst, die, abhängig von Dotierstoffen, die durch Drift in die zumindest eine primäre aktive Region oder aus dieser gespritzt werden, umkehrbar von einer relativ niedrigen Leitfähigkeit zu einer relativ hohen Leitfähigkeit geändert werden kann.

**5.** Der Schalter nach Anspruch 2, wobei der zumindest eine Dotierstoff der sekundären aktiven Region so gewählt ist, dass er die elektrische Leitfähigkeit der zumindest einen primären aktiven Region von einer relativ niedrigen elektrischen Leitfähigkeit zu einer relativ hohen elektrischen Leitfähigkeit oder von einer relativ hohen elektrischen Leitfähigkeit zu einer relativ niedrigen Leitfähigkeit ändert.

**6.** Der Schalter nach Anspruch 5, wobei der Dotierstoff aus einer Gruppe bestehend aus ionisierten interstitiellen oder substitutionellen Störatomen, kationischen Donorspezies, Anionenleerstellen und anionischen Akzeptorspezies ausgewählt ist.

**7.** Der Schalter nach Anspruch 6, wobei der Dotierstoff aus einer Gruppe bestehend aus Wasserstoff, Alkali- und Erdalkalikationen, Übergangsmetallkationen, Seltene-Erde-Kationen, Sauerstoffanionen oder -leerstellen, Chalkogenidanionen oder -leerstellen, Stickstoffanionen oder - leerstellen, Pniktidanionen oder -leerstellen oder Halidanionen oder -leerstellen ausgewählt ist.

8. Der Schalter nach Anspruch 1, wobei das zumindest eine Material für die primäre aktive Region und das Material für die sekundäre aktive Region ausgewählt sind aus der Gruppe bestehend aus:

(1) Oxiden, Sulfiden, Seleniden, Nitriden, Phosphaten, Arseniden und Bromiden von Übergangsmetallen, Seltene-Erde-Metallen und Erdalkalimetallen;
(2) Legierungen ähnlicher Verbindungen aus Liste (1) miteinander; und
(3) gemischten Verbindungen, in denen zumindest zwei unterschiedliche Metallatome mit zumindest einem elektronegativen Element kombiniert sind.

9. Der Schalter nach Anspruch 8, wobei das zumindest eine Material für die primäre aktive Region und das Material für die sekundäre aktive Region aus der Gruppe bestehend aus Titanaten, Zirkonaten, Hafnaten, Legierungen dieser drei Oxide in Paaren oder mit allen drei vorhandenen gemeinsam und Verbindungen des $ABO_3$-Typs, wobei A zumindest ein zweiwertiges Element darstellt und B zumindest eines von Titan, Zirkonium und Hafnium darstellt, ausgewählt sind.

10. Der Schalter nach Anspruch 8, wobei das zumindest eine Material für die primäre aktive Region und das Material für die sekundäre aktive Region ausgewählt sind aus der folgenden Liste:

$TiO_2/TiO_{2-x}$;
$ZrO_2/ZrO_{2-x}$;
$HfO_2/HfO_{2-x}$;
$SrTiO_2/SrTiO_{2-x}$;
$GaN/GaN_{1-x}$;
$CuCl/CuCl_{1-x}$; und
$GaN/GaN:S$.

11. Der Schalter nach Anspruch 1, wobei beide Elektroden Metall, metallische Verbindungen sind oder eine der Elektroden Metall ist und die andere der Elektroden ein Halbleiter ist.

12. Der Schalter nach Anspruch 1, wobei das Positionieren des Dotierstoffs innerhalb der aktiven Region ferner das Anlegen einer Spannung geeigneter Größenordnung und Polarität umfasst, die bewirkt, dass der Dotierstoff in bestimmte Regionen der aktiven Schicht oder von diesen weg driftet.

13. Der Schalter nach Anspruch 1, wobei das Positionieren des Dotierstoffs nahe einer Schnittstelle Elektrode/aktive Region die Schnittstelle Ohm-ähnlich macht und das Positionieren des Dotierstoffs weg von einer Schnittstelle Elektrode/aktive Region die Schnittstelle Schottky-ähnlich macht.

14. Nanodrahtquerbalken (300, 400), umfassend:

eine erste Schicht (302, 404) aus im Wesentlichen parallelen Nanodrähten;
eine zweite Schicht (304, 406) aus im Wesentlichen parallelen Nanodrähten, die die erste Nanodrahtschicht überlagert; und
zumindest einen Nanodrahtschnittpunkt (412-415), der einen elektronischen Schalter bildet, der nach Anspruch 1 konfiguriert ist.

15. Der Querbalken nach Anspruch 14, wobei zwei beliebige Nanodrähte in der ersten Schicht (505, 506) einen elektronischen Schalter bilden, der nach Anspruch 1 konfiguriert ist, und zwei beliebige Nanodrähte in der zweiten Schicht (510, 511) einen elektronischen Schalter bilden, der nach Anspruch 1 konfiguriert ist.

**Revendications**

1. Commutateur électronique (100) comprenant :

- une première électrode (104) ;
- une seconde électrode (106) ; et
- une région active (102) disposée entre la première électrode et la seconde électrode et comprenant au moins un dopant, **caractérisé par le fait que** le commutateur peut être reconfiguré pour fonctionner en tant que redresseur direct (112), redresseur inverse (113), redresseur tête à tête (114) ou redresseur shunté (115) par positionnement de l'au moins un dopant à l'intérieur de la région active pour commander le flux de porteurs de charge à travers le commutateur.

2. Commutateur selon la revendication 1, dans lequel la région active (102) comprend en outre :

- au moins une région active primaire comprenant au moins un matériau pour transporter le dopant qui commande le flux de porteurs de charge à travers le commutateur ; et
- une région active secondaire comprenant au moins un matériau pour fournir une source/puits du dopant pour la au moins une région active primaire.

3. Commutateur selon la revendication 2, dans lequel la région active primaire comprend en outre un matériau qui est électroniquement semi-conducteur, nominalement électroniquement isolant ou faiblement conducteur d'ions.

**4.** Commutateur selon la revendication 2, dans lequel la au moins une région active primaire comprend en outre un film ayant une conductivité électrique qui est capable d'être changée de manière réversible d'une conductivité relativement faible à une conductivité relativement élevée en fonction de dopants qui sont injectés dans ou hors de la au moins une région active primaire par dérive.

**5.** Commutateur selon la revendication 2, dans lequel l'au moins un dopant de la région active secondaire est choisi pour changer la conductivité électrique de la au moins une région active primaire d'une conductivité électrique relativement faible à une conductivité électrique relativement élevée ou d'une conductivité électrique relativement élevée à une conductivité relativement faible.

**6.** Commutateur selon la revendication 5, dans lequel le dopant est choisi dans un groupe constitué par des atomes d'impuretés interstitielles ou substitutionnelles ionisés, des espèces donneuses de cations, des lacunes d'anions et des espèces accepteuses d'anions.

**7.** Commutateur selon la revendication 6, dans lequel le dopant est choisi dans un groupe constitué par des cations hydrogène, alcalins et alcalino-terreux, des cations de métaux de transition, des cations de terres rares, des anions ou des lacunes d'oxygène, des anions ou des lacunes de chalcogénure, des anions ou des lacunes d'azote, des anions ou des lacunes de pnictide, ou des anions ou des lacunes d'halogénure.

**8.** Commutateur selon la revendication 1, dans lequel l'au moins un matériau pour la région active primaire et le matériau pour la région active secondaire sont choisis parmi les groupes constitués par :

> (1) des oxydes, des sulfures, des séléniures, des nitrures, des phosphates, des arséniures et des bromures de métaux de transition, de métaux de terres rares et de métaux alcalino-terreux ;
> (2) des alliages de composés analogues à ceux de la liste (1) les uns avec les autres ; et
> (3) des composés mélangés, dans lesquels il y a au moins deux atomes métalliques différents combinés avec au moins un élément électronégatif.

**9.** Commutateur selon la revendication 8, dans lequel l'au moins un matériau pour la région active primaire et le matériau pour la région active secondaire sont choisis dans le groupe constitué par des titanates, des zirconates, des hafnates, des alliages de ces trois oxydes par paires ou avec les trois présents ensemble, et des composés du type $ABO_3$, A représentant au moins un élément divalent et B représentant au moins l'un parmi le titane, le zirconium et l'hafnium.

**10.** Commutateur selon la revendication 8, dans lequel l'au moins un matériau pour la région active primaire et le matériau pour la région active secondaire sont choisis dans la liste suivante :

> $TiO_2/TiO_{2-x}$ ;
> $ZrO_2/ZrO_{2-x}$ ;
> $HfO_2/HfO_{2-x}$ ;
> $SrTiO_2/SrTiO_{2-x}$ ;
> $GaN/GaN_{1-x}$ ;
> $CuCl/CuCl_{1-x}$ ; et
> GaN/GaN:S.

**11.** Commutateur selon la revendication 1, dans lequel les deux électrodes sont des métaux, des composés métalliques, ou l'une des électrodes est métallique et l'autre des électrodes est un semi-conducteur.

**12.** Commutateur selon la revendication 1, dans lequel le positionnement du dopant à l'intérieur de la région active comprend en outre l'application d'une tension d'une amplitude et d'une polarité appropriées qui amène le dopant à dériver jusqu'à ou à l'opposé de régions particulières de la couche active.

**13.** Commutateur selon la revendication 1, dans lequel positionner le dopant près d'une interface électrode/région active rend l'interface de type ohmique et positionner le dopant à l'écart d'une interface électrode/région active rend l'interface de type Schottky.

**14.** Réseau crossbar à nanofils (300, 400) comprenant :

> - une première couche (302, 404) de nanofils sensiblement parallèles ;
> - une seconde couche (304, 406) de nanofils sensiblement parallèles recouvrant la première couche de nanofils ; et
> - au moins une intersection de nanofils (412-415) formant un commutateur électronique configuré selon la revendication 1.

**15.** Réseau crossbar selon la revendication 14, dans lequel deux nanofils quelconques dans la première couche (505, 506) forment un commutateur électronique configuré selon la revendication 1 et deux nanofils quelconques dans la seconde couche (510, 511) forment un commutateur électronique configuré selon la revendication 1.

Figure 1A

Figure 1B

Figure 2

Figure 3

Figure 4

Figure. 5A

Figure. 5B

Figure. 6

Figure 7B

Figure 7C

Figure 7A

Figure 8A

Figure 8B

Figure 8C

EP 2 311 094 B1

Figure 9B

Figure 9C

910
912

I (μA)
5
-5

-3  -2  -1  0  1  2  3
V (V)

Figure 9A

906
904
908
902
901
905

200
150
100
50
0
-50
Current (μA)

-8  -4  0  4
Voltage (V)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0190605 A